Europäisches Patentamt

European Patent Office

Office européen des brevets

(19)

(11) Publication number: **0 148 601**
A2

## (12) EUROPEAN PATENT APPLICATION

(21) Application number: 84308598.6

(22) Date of filing: 11.12.84

(51) Int. Cl.⁴: **H 05 K 3/20**

(30) Priority: 09.01.84 US 569096

(43) Date of publication of application: 17.07.85
Bulletin 85/29

(84) Designated Contracting States: BE CH DE FR GB IT LI
NL

(71) Applicant: STAUFFER CHEMICAL COMPANY, Westport
Connecticut 06881 (US)

(72) Inventor: Fisher, Paul David, 1303 Kimberly Road,
Anderson, SC 29621 (US)
Inventor: Manocchi, James Charles, 31 Country Ridge
Drive, Monroe CT 06468 (US)

(74) Representative: Smith, Sydney et al, Elkington and Fife
High Holborn House 52/54 High Holborn, London
WC1V 6SH (GB)

(54) Transfer lamination of electrical circuit patterns.

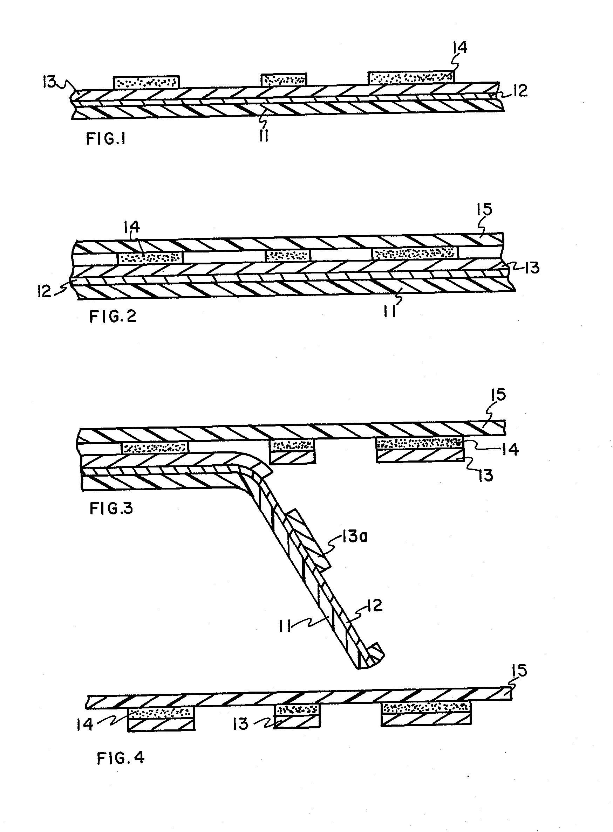

(57) Electrical circuit patterns are adhesively bonded to a dielectric support (e.g., epoxy glass prepreg) by using a transfer laminate. The transfer laminate comprises a release coated carrier film, a metallic layer and an adhesive. After being bonded to the support, the carrier film is stripped therefrom to leave portions of the metal in the form of the conductive pathways of the circuit, adhesively bonded to the support. In fig. 1 a transfer laminate consists of a carrier film 11, a release coating 12, an adherent metal layer 13 on the other side of the release coating and an adhesive pattern 14 which is in the shape of the ultimate desired circuit pattern.

ACTORUM AG

-1-

## TRANSFER LAMINATION OF ELECTRICAL
## CIRCUIT PATTERNS

### Background of the Invention

#### Field of the Invention

The present invention relates to placing electrical circuit patterns on a dielectric substrate using a transfer lamination procedure.

#### Description of the Prior Art

Transfer lamination of vapor deposited foils is shown in U. S. Patent Nos. 4,357,395 and 4,383,003 to E. Lifshin et al. In the former patent, a continuous layer of metal film is applied to a dielectric substrate by means of an electro deposited copper bonding layer with nodules or dendrites, having club-headed portions, which project from the layer to provide reentrant cavities for mechanical interlocking of the film with the substrate. The latter patent achieves bonding of the continuous conductive film to the dielectric substrate by means of an inorganic silica or alumina bonding layer. In both of the above patents it is taught that circuit patterns can be formed from the resulting laminates by conventional subtractive or semi-additive processing.

C-6985

## Summary of the Present Invention

The present invention relates to a transfer laminate useful in bonding a conductive circuit pattern to a dielectric support which comprises: (a) a carrier film; (b) a release coating on one side of the carrier film; (c) a metallic layer, which is adapted to form the conductive circuit pattern, bonded to the release coating; and an exposed resinous adhesive bonded to the metallic layer. The metallic layer bonds preferentially to the adhesive, as compared to the release coating, only in those areas desired for the circuit pattern. When the adhesive is bonded to the desired dielectric support and the carrier film and adherent release coating is removed, the areas of the metal coating adherent to the adhesive remain attached thereto to form the conductive pathways for the circuit with the remainder of the conductive metal remaining with the carrier film.

## Description of the Drawings

The Drawings, which form a portion of the present invention, schematically illustrate, in Figs. 1 - 4, one embodiment of the present invention and, in Figs. 5 - 8, another embodiment wherein:

Fig. 1 is a cross-sectional view of a transfer laminate in accordance with the present invention having a continuous release coating and a discontinuous adhesive coating in the form of the desired conductive pathways of the circuit;

C-6985

Fig. 2 shows lamination of the product of Fig. 1 to a dielectric support;

Fig. 3 shows stripping of the carrier film, release coating and unwanted conductive metal from the dielectric support/adhesive/conductive metal laminate;

Fig. 4 shows the desired product having a conductive circuit pattern adhered to the dielectric support by adhesive; and

Figs. 5 - 8 are generally similar to Figs. 1 - 4 and illustrate another embodiment of the present invention in which a continuous layer of adhesive is used with a discontinuous release coating. The release coating is present in areas immediately adjacent the portions of the metal which are desired to form the conductive pathways for the circuit pattern.

## Detailed Description of the Present Invention

The preferred transfer laminate of the present invention is shown in Fig. 1 and comprises a carrier film 11, a release coating 12 bonded to one side of the carrier film, an adherent metal layer 13 attached to the side of the release coating remote from the carrier film, and an adhesive pattern 14 which is in the shape of the ultimate desired circuit pattern.

The carrier film 11 can be chosen from a wide variety of materials including metal, paper, polymers, and the like. Preferred materials, from the viewpoint of economics, include paper and thermoplastic films such as polyethylene terephthalate (polyester). Generally, in a preferred embodiment the thickness of carrier film 11 can range from about 12.7 to about 76.2 microns.

- 4 -

In order to achieve the desired degree of smooth release of the metallic layer 13 from the carrier film 11, a suitable release coating 12 is placed on the carrier film. The thickness of this layer can be quite small, ranging from a monoatomic coating up to about 7 microns. Conventional release coatings can be used. Suitable release coatings include the silicones, polyurethanes, and the like.

The next layer in the transfer laminate is a conductive metal layer 13 formed of a suitable conductive metal such as copper or aluminum. The thickness of this layer can generally range from about 0.5 to about 3.0 microns.

The combination of metal layer 13, release coating 12 and carrier film 11 can be suitably formed by depositing the metal layer 13 onto commercially available release coated carriers, e.g., polyester, by using conventional deposition techniques (e.g., vacuum deposition, thermal evaporation, cathodic sputtering, electron-beam sputtering, etc.).

Once the metal layer/release coating/carrier film subcombination has been formed, a suitable adhesive pattern 14 can be printed onto the metal layer 13 in the ultimate shape desired for the electrical pathways of the circuit. The adhesive chosen should exhibit a sufficiently high degree of adhesion to both the metal layer 12 and dielectric support 15 to which the metal is to be bonded by the adhesive 14. It should have acceptably high thermoset characteristics so that after transfer it has good high temperature resistance and cohesiveness to preclude undesired flow with distortion of the conductive circuit pathways. In a preferred

C-6985

- 5 -

embodiment, when screen printing techniques are used to print the adhesive pattern, the adhesive which is used should, when combined with solvent, have a viscosity which is compatible with screen printing (e.g., 6000 - 10,000 cps), should have a coefficient of pseudo-plasticity (e.g., 0.7 - 0.9) which insures a substantially non-dripping composition when on the screen but which is plastic enough to flow through the screen when stress is applied thereto, and should have solvents which are not so rapid drying as to have the adhesive dry to a non-flowable state on the screen. Hydroxyl functional polyester or polyether resins which are curable with isocyanates have been shown to be adhesives that can be used when the adhesive 14 is to be screen printed onto the metal layer. Its thickness can be 10 - 50 microns.

If desired, the exposed face of the adhesive pattern 14 can be covered with a release liner, e.g., of paper, to retard contamination of the adhesive with foreign matter in accordance with conventional practice.

The laminate of Fig. 1 (with or without optional release liner) is used to bond the desired adhesively bound pattern of metal to a suitable dielectric support 15 by following the procedures of Figs. 2 - 4. Suitable dielectric supports are well known in the art and include polymeric materials in film and sheet form, e.g., polyester, polyimide, glass epoxy prepreg boards, phenolic-resin paper prepregs, and the like. The exposed adhesive 14 of the laminate is bonded to the dielectric support 15 as shown in Fig. 2. Thereafter, the carrier film 11, adherent release layer 12 and metal portions 13a not touching adhesive 14 are stripped from the

C-6985

resulting laminate as shown in Fig. 3 to leave the dielectric support/adhesive/metal circuit pattern product shown in Fig. 4.

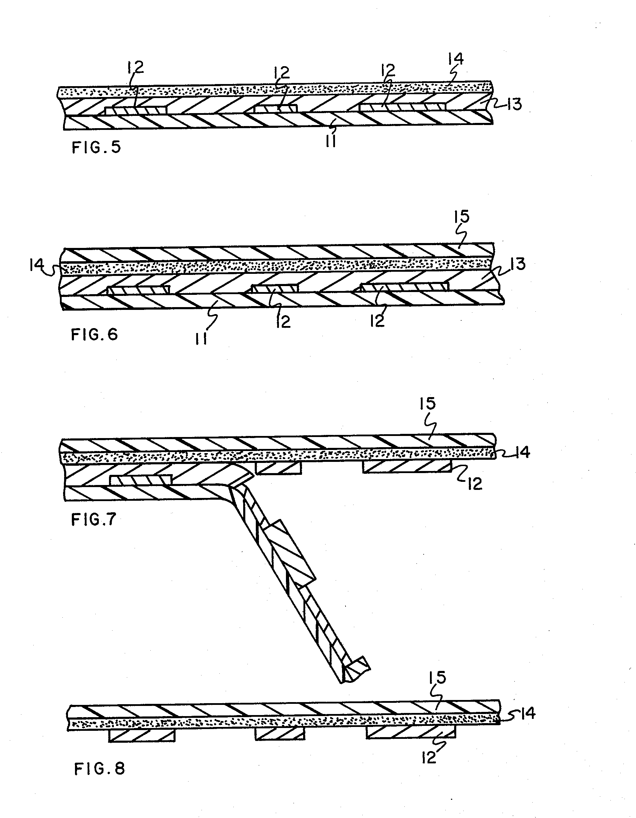

Figs. 5 - 8 show another embodiment of the present invention wherein a continuous layer of adhesive 14 is employed in conjunction with a discontinuous release layer 12 (e.g., by vacuum deposition or printing, e.g., through a suitable mask). The release coating pattern corresponds to the conductive metal pathways for the desired circuit pattern. When the laminate resulting from bonding the laminate of Fig. 5 to a dielectric support has its carrier film 11 stripped therefrom (as shown in Fig. 7), the release coating portions only allow for retention of metal on the adhesive in a pattern which gives the desired circuit pattern. The absence of a release coating in adjacent portions insures that the metal overlying those portions sticks to the carrier film and is removed as it is removed.

As will be understood by the person or ordinary skill in the art, a variety of conventional materials may be selected as carrier film 11, release coating 12, metal layer 13 and adhesive 14. For example, various metals and polymers, as well as paper, can be used as carrier film 11. The metallic layer 13 can be various conductive metals (e.g., silver, aluminum, gold, etc., or their alloys). Similarly, the dielectric support 15 can be selected from a variety of suitable materials. Representative supports include both rigid (e.g., phenolic-paper, ceramic, etc.) as well as flexible (e.g., polyester, polyimide, PVC, etc.) support materials.

Two other aspects of the invention are (1) the laminate intermediate, shown in Figs. 2 and 6, formed when the dielectric support is adhesively bonded to the carrier film/release coating/metallic layer transfer laminate subcomponent and (2) the conductive circuit/ adhesive/dielectric support end product shown in Figs. 4 and 8.

The laminate intermediate shown in Figs. 2 and 6 can be formed by having adhesive on the carrier film 11/ release coating 12/metal 13 transfer laminate or by having it on the dielectric support 15. In either case, bonding the dielectric support to the transfer laminate will form a novel structure which can be utilized to form the desired end product of Figs. 4 and 8 after the transfer laminate is removed to leave the desired metal portions that form the conductive pathways for the circuit.

The end product of Figs. 4 and 8 is itself, a novel structure. The adhesive attachment of thin, deposited metal conductive pathways to the dielectric support is accomplished by such a structure.

The present invention has a number of advantages over conventional approaches including:

(1) liquid chemical systems are not used so as to obviate any of the problems inherent with liquid waste disposal;

(2) photoresist methods are not needed for the present system;

(3) the waste from the present process is solid and can be reclaimed;

(4) precious metals are not lost as is the case with certain other processes that use conductive ink printing; and

- 8 -

(5) the present process can be used to form low power circuitry which can be soldered.

The present invention is further illustrated by the Examples which follow.

C-6985

- 9 -

EXAMPLE 1

This Example illustrates a transfer metallization process in which circuit patterns are formed on a polyethylene terephthalate film.

The adhesive described below was formulated for screen printing onto a commercially available "hot stamp" foil (3193 IX brand from the Thermark Division of Avery Corp). The foil comprised vacuum metallized aluminum attached to a wax release coating on a 12.7 micron polyethylene terephthalate film. The ingredients comprising the adhesive were formed by mixing parts A and B listed below (all amounts in parts by weight with the parentheticals giving the solids amounts).

| Ingredients | Part A |
|---|---|
| Modified polyester resin (Morton ADCOTE 76 PI) | 120.0 (61.2) |
| Modified polyester resin (Hughson 7904) | 24.0 (14.3) |
| Brominated epoxy resin (Dow D.E.R. 542) | 18.0 (18.0) |
| Brominated epoxy resin (CIBA Araldite 8011A75) | 5.0 (3.8) |
| Isocyanate hardener (Bostik BOSCODUR No. 1) | 9.0 (5.9) |

The solids content of Part A was 58.6% on a weight basis.

| Ingredients | Part B |
|---|---|
| Diatomaceous earth (Johns Manville SUPERFINE diatomite) | 5.0 (5.0) |
| Precipitated silica (PQ Corp. SV-500) | 15.0 (15.0) |
| Part A, above | 50.0 (29.3) |

The total solids content of the resulting mixture was 70.4% by weight.

C-6985

The adhesive thus formed was screen printed onto the hot stamp foil using a 120 mesh stainless steel and a DeHaart Model AOL-12E automatic screen printer. The screen employed an Institute of Printed Circuits test pattern for circuitry (AM-IPC-240). After the adhesive was printed onto the foil, it was dried at 185°F (85°C) for six minutes in an air circulating oven. The sample was removed from the oven and laminated at room temperature to a 50.8 micron thick polyester film (MYLAR brand from Du Pont). This was followed by hot nipping at 190°F (88°C) at a speed of 2.74 meter per minute between rubber and steel rollers. The 12.7 micron polyethylene terephthalate film contained in the original hot stamp foil was removed leaving the desired circuit pattern adhesively attached to the 50.8 micron film. A waxy residue, from the original wax release layer of the hot stamp foil, was on the surface of the circuit pattern.

C-6985

- 11 -

EXAMPLE 2

This Example illustrates the transfer metallization process used to form a circuit pattern.

The following urethane adhesive was used (solids parts by weight in parenthesis):

| Ingredients | Parts By Weight | |
|---|---|---|
| Modified polyester (Morton ADCOTE 76P1) | 120.0 | (61.2) |
| Modified polyester (Hughson 7904) | 24.0 | (14.3) |
| Fumed silica (Cabot CAB-O-SIL M5) | 3.5 | (3.5) |
| Modified isocyanate (Morton 9H1) | 10.8 | (4.3) |

The adhesive as formed had a solids content of 52.6%. Anhydrous toluene (15 gm) was added to reduce the viscosity to 48% solids.

The resulting adhesive was screen printed onto "hot-stamp" foil as described in Example 7. The resulting laminate was dried for 5 minutes at 190°F. (87.8°C.), was nipped at room temperature to 50.8 micron polyethylene terephthalate film and was then hot nipped at 250°F. (121.1°C.). The polyethylene terephthalate film was removed leaving a circuit pattern with good definition on the 50.8 micron polyethylene terephthalate film.

C-6985

## EXAMPLE 3

This Example illustrates a particularly preferred embodiment of the present invention describing adhesive formulations suitable for use analogous to the type shown in Example 2.

The following two urethane adhesives were formulated (solids content in parenthesis):

| Ingredients | A | B |
|---|---|---|
| Modified polyester (Morton ADCOTE 76P1-60) | 102.0 (61.2) | 102.0 (61.2) |
| Modified polyester (Hughson 7904) | 24.0 (14.3) | 24.0 (14.3) |
| Propylene glycol methyl ether acetate (ARCOSOLVE PM acetate brand from Arco) | 18.0 ( -- ) | 27.0 ( -- ) |
| Amorphous silica gel (SYLOID 244 from W. R. Grace) | 10.0 (10.0) | 20.0 (20.0) |
| Modified isocyanate (Morton ADCOTE 9H1) | 10.8 (4.3) | 10.8 (4.3) |

The solids content of A was 54.5% by weight, and of B, 54.3%.

Each of the foregoing formulations was multiplied by a factor of four and added to a pebble mill mixer and mixed for sixteen hours (except for the isocyanate curing agent). After addition of the isocyanate, the viscosity of each was determined at various shear rates. Both formulations had a pseudoplastic ratio of about 0.9 which is a desirable rheology. When screen printed the formulations did not dry on the screen and produced suitable patterns with no "stringing".

As described in Example 2, they were printed on "hot stamp" foil and laminated to 50.8 micron polyester film. The results were very acceptable.

- 13 -

The foregoing Examples illustrate certain embodiments of the present invention but should not be construed in either a limited or restrictive sense since the scope of protection sought is set forth in the claims which follow.

C-6985

CLAIMS:

1. A transfer laminate which is adapted to bond a conductive circuit pattern to a dielectric support which comprises:

a) a carrier film;

b) a release coating bonded to the carrier film on one side thereof;

c) a conductive metallic layer, which is adapted to form the conductive circuit pattern, bonded to the release coating; and

d) an exposed resinous adhesive bonded to the metallic layer, the metallic layer bonding preferentially to the adhesive, as compared to the release coating, only in those areas desired for the conductive pathways of the circuit pattern.

2. A transfer laminate as claimed in claim 1 characterised in that the carrier film is formed of polyester.

3. A transfer laminate as claimed in claim 2 characterised in that the release coating is formed of silicone.

4. A transfer laminate as claimed in any of claims 1 to 3 characterised in that the metallic layer is copper.

4. A transfer laminate as claimed in any of claims 1 to 3 characterised in that the metallic layer is copper.

5. A transfer laminate as claimed in any of claims 1 to 4 characterised in that the adhesive comprises a hydroxyl functional resin curable with isocyanates.

6. A transfer laminate as claimed in any of claims 1 to 5 characterised in that the carrier film has a thickness of from about 12.7 microns to about 76.2 microns.

7. A transfer laminate as claimed in any of claims 1 to 6 characterised in that the metallic layer has a thickness of from about 0.5 to about 3.0 microns.

0148601

- 15 -

8. A transfer laminate as claimed in any of claims 1 to 7 characterised in that the adhesive has a thickness of from about 10 to about 50 microns.

9. A transfer laminate as claimed in any of claims 1 to 8 characterised in that the adhesive is in a pattern corresponding to the conductive pathways desired for the circuit and the release coating is a continuous layer.

10. A transfer laminate as claimed in any of claims 1 to 8 characterised in that the adhesive is in a continuous coating and the release coating is in a pattern corresponding to the conductive pathways desired for the circuit.

11. A method of forming a circuit pattern on a dielectric support which comprises:

(a) adhesively bonding to the dielectric support a transfer laminate as claimed in any of claims 1 to 10 and

(b) removing from the thus formed composite the carrier film and release coating of the transfer laminate so as to leave portions of the metallic layer adhesively bonded to the dielectric substrate in the form of a circuit pattern.

12. A method as claimed in claim 11 characterized in that the dielectric support is a glass epoxy prepreg board.

13. A laminate intermediate which is adapted to be used in the bonding of a conductive circuit pattern to a dielectric support which comprises a transfer laminate as claimed in any of claims 1 to 10 with a dielectric support bonded to the adhesive on its side opposite to the metallic layer.

14. A laminate intermediate as claimed in claim 13 characterized in that the dielectric support is a glass epoxy prepreg board.

15. A conductive circuit pattern formed of metal which is adhesively bonded to a dielectric support, the metal having a thickness of no more than about 3 microns.

16. A product as claimed in claim 15 characterized in that the dielectric support is a glass epoxy prepreg board.

17. A product as claimed in claim 15 or claim 16 characterized in that the metal is copper.

18. A product as claimed in claim 17 characterized in that the metal has a thickness of from about 0.5 to about 3 microns.

FIG.1

FIG.2

FIG.3

FIG.4

0148601

2 / 2

FIG. 5

FIG. 6

FIG. 7

FIG. 8